# EUROPÄISCHE PATENTSCHRIFT

(11) **EP 1 690 303 B1**
(45) Veröffentlichungstag und Bekanntmachung des Hinweises auf die Patenterteilung: **03.11.2010**
(21) Anmeldenummer: 04762587.6
(22) Anmeldetag: 04.08.2004
(51) Int. Cl.: H01L 41/083

(54) **PIEZOAKTOR**
PIEZO ACTUATOR
PIEZO-ACTIONNEUR

(30) Priorität: 01.10.2003 DE 10345730
(43) Veröffentlichungstag der Anmeldung: 16.08.2006
(73) Patentinhaber: ROBERT BOSCH GMBH, 70442 Stuttgart (DE)
(72) Erfinder: ENDRISS, Axel, 70378 Stuttgart (DE)
(86) Internationale Anmeldenummer: PCT/DE2004/001742
(87) Internationale Veröffentlichungsnummer: WO 2005/041315

(56) Entgegenhaltungen:
- WO-A-03/052260
- US-A- 5 382 865
- US-B2- 6 445 111
- PATENT ABSTRACTS OF JAPAN Bd. 1998, Nr. 04, 31. März 1998 (1998-03-31) & JP 09 321359 A (KYOCERA CORP), 12. Dezember 1997 (1997-12-12) -& JP 09 321359 A (KYOCERA CORP) 12. Dezember 1997 (1997-12-12)
- PATENT ABSTRACTS OF JAPAN Bd. 2002, Nr. 12, 12. Dezember 2002 (2002-12-12) & JP 2002 246666 A (MATSUSHITA ELECTRIC IND CO LTD), 30. August 2002 (2002-08-30) -& JP 2002 246666 A (MATSUSHITA ELECTRIC IND CO LTD) 30. August 2002 (2002-08-30)

## Beschreibung

### Stand der Technik

Die Erfindung betrifft einen Piezoaktor, beispielsweise zur Betätigung eines mechanischen Bauteils, und einen mechanisch mit dem Piezoaktor gekoppelten Sensor, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung an diese piezoelektrischen und elektrostriktiven Keramiken erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt.

Aufgrund des extrem schnellen und genau regelbaren Hubeffektes können solche Piezoaktoren zum Bau von Stellern, beispielsweise für den Antrieb von Schaltventilen bei Kraftstoffeinspritzsystemen in Kraftfahrzeugen vorgesehen werden. Hierbei wird die spannungs- oder ladungsgesteuerte Auslenkung dieses Piezoaktors zur Positionierung eines Steuerventils genutzt, das wiederum den Hub einer Düsennadel regelt.

Da die erforderlichen elektrischen Feldstärken zur Betätigung des Piezoaktors im Bereich von mehreren kV/mm liegen und in der Regel moderate elektrische Spannungen zur Ansteuerung gewünscht sind, erfolgt der Aufbau dieses Piezoaktors hier in mehreren Schichten von übereinandergestapelten metallisierten Piezokeramiken zu einem sog. Multilayer-Aktor. Hierzu sind jeweils zwischen den Schichten Innenelektroden vorhanden, die z.B. mit einem Druckverfahren aufgebracht werden, und es sind Außenelektroden vorhanden, über die die elektrische Spannung angelegt wird. Ein typisches Verfahren zum Herstellen solcher Schichten besteht in der Foliengießtechnik. Die einzelnen Schichten werden dabei zur Herstellung der Innenelektroden metallisiert und übereinandergestapelt, wobei dann zwischen zwei Schichten mit Innenelektroden unterschiedlicher Polarität sich der Piezoeffekt auswirkt.

Das eigentliche Piezoelement kann dabei entweder aktiv als Piezoaktor, wie zuvor beschrieben, oder passiv als Sensor benutzt werden, bei dem die Spannung abgegriffen wird, welche entsteht, wenn das Piezoelement durch eine mechanische Einwirkung verformt wird.

Eine solche Anordnung ist beispielsweise in der DE 199 60 971 A1 beschrieben. Das abgreifbare Spannungssignal ist dabei als Drucksensor proportional zur einwirkenden Kraft oder als Wegsensor proportional zur einwirkenden Deformation. Um die Längenänderung eines Piezoaktors geregelt einzustellen muss diese erfasst werden, weshalb bislang ein separates Bauteil als Sensorelement vonnöten ist. Hierzu kann z.B. ein Dehnungsmessstreifen auf den Piezoaktor aufgeklebt, ein induktiver Wegaufnehmer oder, wie im zuvor genannten Stand der Technik beschrieben, ein weiterer Piezosensor eingesetzt werden.

In der Schrift JP 09 321359 A ist ein Piezoaktor mit einem Mehrschichtaufbau von Piezolagen offenbart, wobei Piezolagen für einen Aktorteil und Piezolagen für einen Sensorteil in einem Bauteil als Piezoaktor integriert sind.

### Vorteile der Erfindung

Der eingangs beschriebene Piezoaktor ist, wie erwähnt, mit einem Mehrschichtaufbau von Piezolagen und in einem piezoelektrisch aktiven Bereich mit zwischen den Lagen angeordneten Innenelektroden aufgebaut und mit einer von Schicht zu Schicht wechselnden Kontaktierung der Innenelektroden, zur Beaufschlagung mit einer elektrischen Spannung, versehen. Zur Bildung eines Sensors sind weitere Piezolagen mit Innenelektroden vorhanden, an den ein der Betätigung des Piezoaktors proportionales elektrisches Sensorsignal über weitere Außenelektroden abnehmbar ist. Die Piezolagen sind für den Aktorteil und die Piezolagen für den Sensor in einem Bauteil derart integriert, dass einzelne Piezolagen für den Sensor in vorgegebenen Abständen zwischen den Piezolagen für den Aktorteil angeordnet sind.

Somit sind das aktive Piezoelement als Piezoaktor und das passive Piezoelement als Sensor in einem Bauteil vereint. Von beiden Funktionen, nämlich Weg und/oder Kraft erzeugen und Weg und/oder Kraft messen, kann unabhängig voneinander gleichzeitig Gebrauch gemacht werden. Es wird kein weiteres zusätzliches Bauteil als Sensor benötigt, wodurch sich vor allem Kosten- und Bauraumvorteile ergeben.

Darüber hinaus vereinfacht die integrierte Lösung die Montage des Piezoaktors, da der Sensor und der Aktor Bestandteil ein und desselben Bauteils sind und somit eine problembezogene spezifische Montage sowie gegebenenfalls weitere hierzu benötigte Bauteile, z.B. eine geschliffenen Passung im Falle einer Kraftmessdose, entfällt.

Ein solches Aktor-Sensor-Element bietet insbesondere dort Vorteile wo einerseits eine hohe Weggenauigkeit erforderlich ist, z.B. im µm- und im Sub-µm-Bereich, und sich aus Bauraumgründen andererseits keine weiteren Bauteile unterbringen lassen.

Die Einspritzung von Kraftstoff lässt sich mittels einer direkten Ventil-Nadelsteuerung für die Anwendung in einem Kraftstoffeinspritzsystem in einem Kraftfahrzeug steuern, wobei hier sogar eine Ventilnadelregelung realisierbar ist.

Bei den nachfolgend beschriebenen Ausführungsbeispielen kann ein Piezoaktor mit einem Piezosensor in einem Bauteil dadurch kombiniert werden, indem einzelne Piezoelemente aufeinander gestapelt und dann getrennt nach Funktion separat angesteuert (Aktor) bzw. ausgelesen (Sensor) werden. Mechanisch in Reihe geschaltete Piezolagen werden dazu elektrisch parallel geschaltet.

Je nach Anwendung kann eine große Anzahl aktiver Piezolagen des Aktorteils einer vergleichsweise geringen Anzahl passiver Piezolagen des Sensors gegenüberstehen oder umgekehrt. Da die Absolutbeträge der Dehnung beim Piezoeffekt gering, die damit verbundenen Ladungsmengen hingegen aber groß sind, kann eine Vielzahl aktiver Elemente wenigen passiven Elementen gegenüberstehen. Die Stapelung kann hierbei in sinnvoller Weise so erfolgen, dass nach einer gewissen Anzahl aktiver Piezolagen, z.B. 20, jeweils ein Sensorelement, bestehend aus mindestens einer passiven Lage, eingebaut bzw. kontaktiert wird. Das Sensorelement ist erfindungsgemäß des weiteren in mehrere einzelne, nebeneinander angeordnete Segmente unterteilt, wodurch das Sensorsignal mehrfach abgegriffen werden kann und sich damit die Ausfallsicherheit erhöht.

Ob es sich bei dem Stapelaufbau um zusammengeklebte einzelne Piezolagen oder um im sogenannten Grünzustand gestapelte und dann zu einem Keramikkörper zusammen gesinterte Einzelschichten (Cofiring-Verfahren) handelt ist für die vorteilhafte Funktion der Erfindung unerheblich.

Bei einem Ausführungsbeispiel ist es vorteilhaft, wenn bei einem rechteckigen Querschnitt des Piezoaktors die elektrisch positiven und negativen Außenelektroden des Aktorteils und des Sensors-an gegenüberliegenden Seiten des Piezoaktors angebracht sind, diese aber um 90° gegeneinander versetzt nach außen treten. Es können aber auch die Außenelektroden sowohl des Aktorteils als auch des Sensors zusammen auf zwei sich gegenüberliegenden Seiten des Piezoaktors angeordnet werden.

Bei einem anderen vorteilhaften Ausführungsbeispiel sind die Innenelektroden der Sensorteile in den Eckbereich des Piezoaktors geführt und sind dort jeweils mit den Außenelektroden kontaktiert. Bei mehreren Sensorteilen können die jeweiligen Innenelektroden vorteilhaft wechselseitig mit Außenelektroden an unterschiedlichen Flanken des Eckbereichs kontaktiert werden.

Enthält das Bauteil mehrere in Wirkrichtung mechanisch zueinander parallel geschaltete Sensorelemente, so können diese zueinander elektrisch parallel geschaltet werden, indem die jeweiligen Innenelektroden gleicher Polarität gemeinsam auf der Außenseite kontaktiert werden, wodurch die Sensitivität des Sensors verbessert wird.

Gemäß einer anderen vorteilhaften Ausführungsform sind bei einer Mehrzahl von Sensorteilen, die mit Außenelektroden kontaktiert sind, die jeweiligen Innenelektroden der Sensorteile mit gleicher Polarität in Wirkrichtung des Piezoaktors hintereinander auf einer Seite des Piezoaktors kontaktiert.

### Zeichnung

Vorteilhafte Ausführungsbeispiele eines erfindungsgemäßen Piezoaktors mit integrierten Sensoren werden anhand der Zeichnung erläutert. Es zeigen:
Figur 1 einen Schnitt durch einen nicht erfindungsgemäßen Piezoaktor mit einem Mehrschichtaufbau von Lagen aus Piezokeramik und zwischenliegenden Innenelektroden sowohl für einen Aktor- als auch für einen Sensorteil,
Figur 2 einen Schnitt entsprechend Figur 1, wobei der Piezoaktor hier allerdings in mehrerer aktive Aktor- und passive Sensorteile unterteilt ist,
Figur 3 einen Querschnitt durch den Piezoaktor nach der Figur 1,
Figur 4 einen Querschnitt durch einen Piezoaktor mit zwei nebeneinanderliegen Sensor-Piezolagen,
Figur 5 einen Querschnitt durch einen Piezoaktor mit drei nebeneinanderliegenden Sensor-Piezolagen,
Figur 6 und Figur 7 einen Querschnitt und eine perspektivische Darstellung eines Piezoaktors mit einem Aktor- und einem Sensorteil, die jeweils an der gleichen Seite des Piezoaktors kontaktiert werden,
Figur 8 und Figur 9 eine weitere Variante des Ausführungsbeispiels nach den Figuren 6 und 7,
Figur 10 und Figur 11 einen Querschnitt und eine perspektivische Darstellung eines Piezoaktors mit kleineren an den Ecken kontaktierten Innenelektroden für das Sensorteil.

### Beschreibung der Ausführungsbeispiele

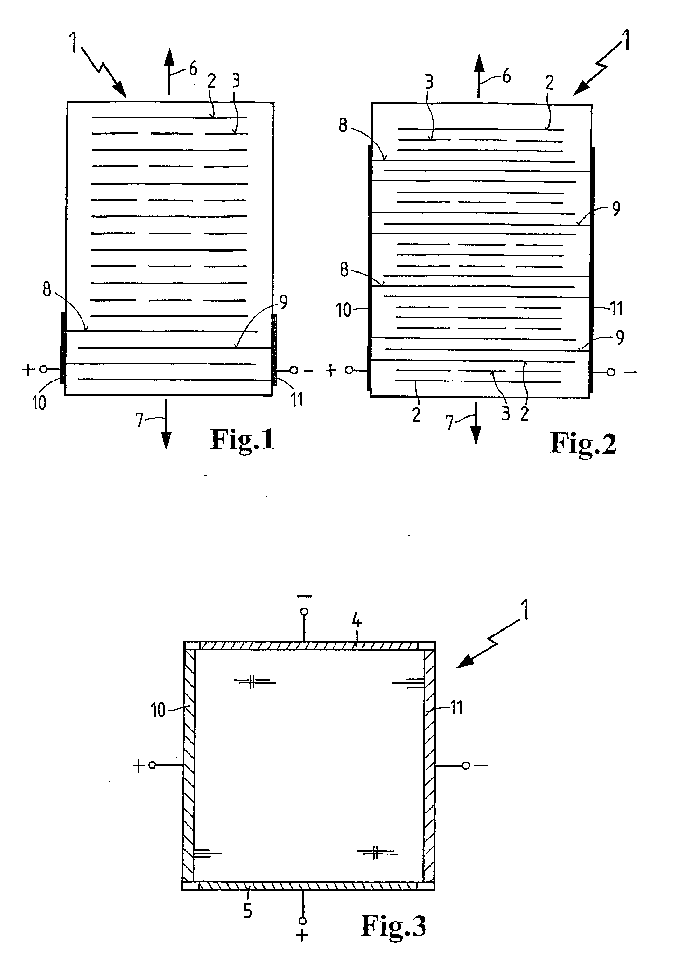

In Figur 1 ist ein Piezoaktor 1 gezeigt, der in an sich bekannter Weise aus Piezolagen eines Keramikmaterials, z.B. sogenannte Grünfolien, mit einer geeigneten Kristallstruktur aufgebaut ist, so dass unter Ausnutzung des sogenannten Piezoeffekts bei Anlage einer äußeren elektrischen Gleichspannung an Innenelektroden 2 und 3 über hier nicht näher dargestellte, jedoch aus Figur 3 ersichtliche Außenelektroden 4 und 5 eine mechanische Reaktion des Piezoaktors 1 in Wirkrichtung 6 bzw. 7 erfolgt. Die Piezolagen mit den Innenelektroden 2 und 3 sind hier über den ganzen Aufbau des Piezoaktors 1 in Wirkrichtung 6 bzw. 7 verteilt und in einer aus dem Stand der Technik bekannten Weise beispielsweise durch Sinterung miteinander verbacken.

Der Längsschnitt durch den Piezoaktor 1 nach der Figur 1 zeigt somit einen Stapelaufbau, bei dem die aktiven Piezolagen mit den jeweiligen Innenelektroden 2 und 3 senkrecht zur Zeichenebene, alternierend einmal ober-, einmal unterhalb, an der Außenseite des Piezoaktors 1 kontaktiert werden. Weiterhin sind passive Piezolagen mit Innenelektroden 8 und 9 zwischen diesen aktiven Piezolagen angeordnet, wobei diese Sensor-Piezolagen um 90° versetzt nach links an eine Außenelektrode 10, bzw. nach rechts an eine Außenelektrode 11 geführt und dort kontaktiert sind. Die um 90° versetzte Anordnung von Sensor- und Aktorteil ist dabei nicht notwendigerweise erforderlich.

In analoger Weise erfolgt der Aufbau für den in Figur 2 gezeigten Fall, bei welchem mehrere Aktor- und Sensorteile mechanisch in Reihe und elektrisch parallel geschaltet sind.

Ersichtlich ist dieser Aufbau auch aus der Querschnittsdarstellung nach der Figur 3, aus der zu erkennen ist, dass die Außenelektroden 4 und 5 zur Aktivierung des Piezoaktors 1 auf den zwei in dieser Darstellung oben und unten gegenüberliegenden Seiten des Piezoaktors 1 und die Außenelektroden 10 und 11 für den Sensorteil rechts und links gegenüberliegend auf dem Piezoaktor 1 angebracht sind. Weitere Abwandlungen mit segmentierten Sensorteilen und Alternativen der Kontaktierung der Innenelektroden nach außen durch eine besondere Vergrabung der Innenelektroden 2 und 3 bzw. 8 und 9 im Piezoaktor 1 werden anhand der folgenden Ausführungsbeispiele erläutert.

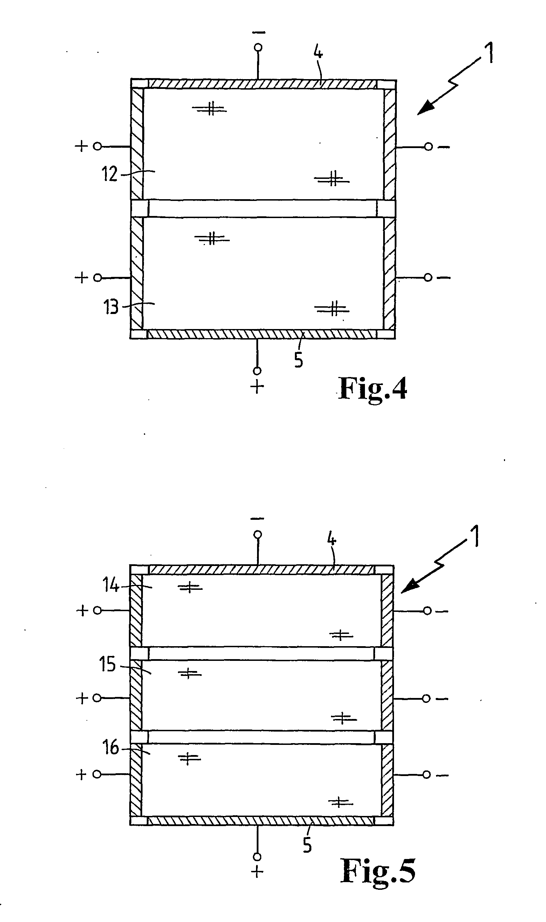

Eine erfindungsgemäße Ausführung hinsichtlich der Gestaltung des Sensors zeigt Figur 4; dort sind in Abwandlung zu dem vorherigen Ausführungsbeispiel jeweils zwei Sensorschichten mit entsprechenden Sensor-Piezolagen 12 und 13 nebeneinander in einer Ebene untergebracht, weshalb das Sensorsignal zur Erhöhung der Messsicherheit zweifach anstatt einfach an entsprechenden Außenelektroden abgegriffen werden kann. Durch ein entsprechendes Abändern des Designs des Piezoaktors 1 für die Sensorinnenelektroden können diese noch weiter unterteilt werden und somit kann auch eine dreifache Segmentierung mit Sensor-Piezolagen 14, 15 und 16 nach Figur 5 in einfacher Weise hergestellt werden.

Durch eine solche Segmentierung der Sensorinnenelektroden oder auch einer sequentiellen Unterteilung in Längsrichtung kann mehr als nur ein Sensorsignal abgegriffen werden. So besteht grundsätzlich die Möglichkeit, diese entweder getrennt zu nutzen oder diese parallel zu schalten zur Verdoppelung, bzw. Vervielfachung des Sensorsignals.

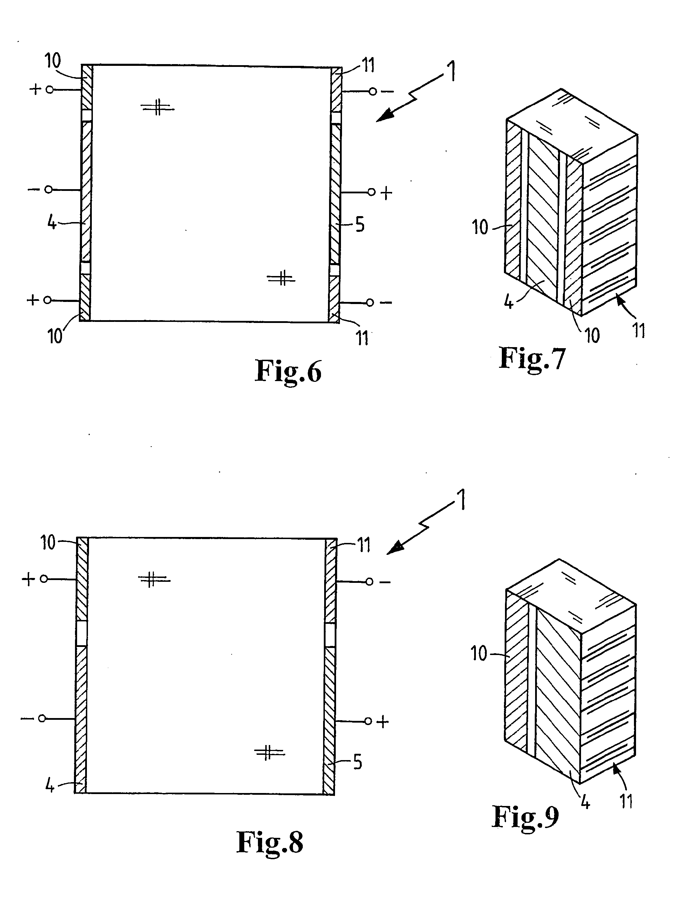

Anhand von zwei weiteren Ausführungsbeispielen nach Figur 6 und 7 sowie nach Figur 8 und 9 sind weitere Varianten mit Kontaktierungsmöglichkeiten für den Aktor- und Sensorteil auf der jeweils gleichen Seite des Piezoaktors 1 gezeigt, wobei die Figuren 7 und 9 jeweils eine perspektivische Darstellung des Ausführungsbeispiels nach den Figuren 6 bzw. 8 zeigen. Da die Funktionen der Bauelemente im wesentlichen denen der Figuren 1 bis 3 entsprechen sind die Bezugszeichen hier analog gewählt. Hierbei ist auch das Sensorteil, wie mit den Figuren 4 und 5 gezeigt, in mehrere nebeneinanderliegende Teile segmentiert.

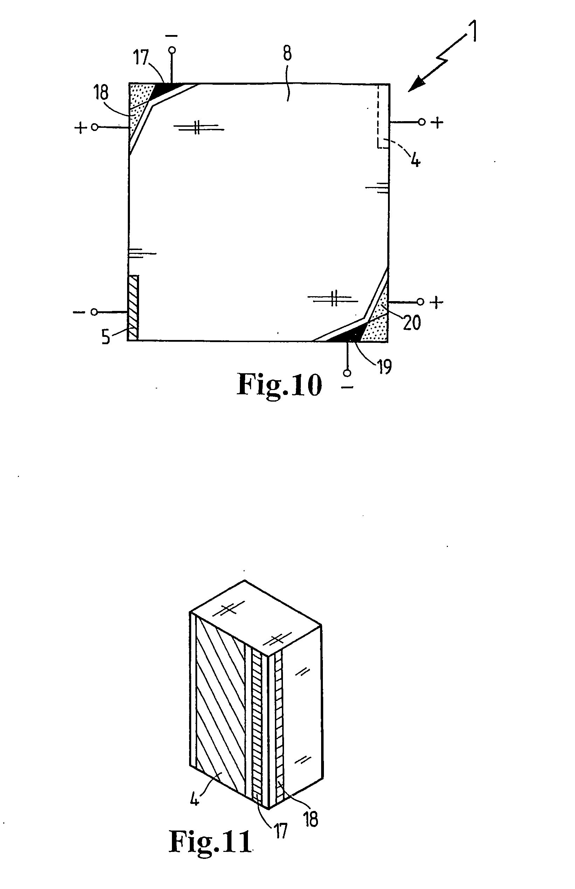

In Figur 10 und der dazugehörigen Figur 11 ist ein Ausführungsbeispiel angegeben, mit dem eine weitere vorteilhafte Kombination von Aktor- und Sensorteil ermöglicht wird, bei welcher das Innenelektrodendesign dergestalt abgeändert ist, dass in jeder Piezolage eine Aktor- und eine oder mehrere Sensor-Piezolagen vorhanden sind. Die jeweils kleinere Kondensatorfläche 17, 18 bzw. 19, 20 der Sensorinnenelektroden nach den Figuren 10 und 11 steht dabei einer größeren Anzahl an Sensor-Piezolagen gegenüber, wodurch auch hier ein akzeptables Sensorausgangssignal erzielt werden kann. Besonders vorteilhaft an dieser Variante ist, dass sich hier ein Ausfall weniger einzelner Schichten, z.B. durch partielle Ablösung der Außenkontaktierung, nur wenig bemerkbar macht. Insbesondere im Falle einer zweifachen Ausführung des Sensorteils besitzt diese Variante eine erhöhte Sicherheit.

## Patentansprüche

1. Piezoaktor, mit
- einem Mehrschichtaufbau von Piezolagen, senkrecht zur Wirkrichtung (6,7) zwischen den Piezolagen angeordneten Innenelektroden (2,3), die zur Betätigung des Piezoaktors über Außenelektroden mit einer elektrischen Spannung beaufschlagbar sind, und mit
- weiteren Piezolagen mit Innenelektroden (8,9), an denen ein der Betätigung des Piezoaktors (1) proportionales elektrisches Sensorsignal über weitere Außenelektroden (10,11) abnehmbar ist, wobei
- die Piezolagen für den Aktorteil und die Piezolagen für das mindestens eine Sensorteil in einem Bauteil als Piezoaktor (1) derart integriert sind, dass einzelne Sensor-Piezolagen in vorgebbaren Abständen oder Anordnungen zwischen den Piezolagen für den Aktorteil angeordnet sind, **gekennzeichnet durch**
- eine Mehrzahl von Sensorteilen, die jeweils einzeln mit Außenelektroden kontaktiert sind, wobei die jeweiligen Sensor-Piezolagen (12,13;14,15,16) der Sensorteile nebeneinander in einer Ebene quer zur Wirkrichtung (6,7) angeordnet sind und
- bei diesen Sensorteilen die Innenelektroden (8,9) mit jeweils gleicher Polarität in Wirkrichtung (6,7) des Piezoaktors (1) parallel nebeneinander auf einer Seite des Piezoaktors (1) mit Außenelektroden kontaktiert sind.

2. Piezoaktor nach Anspruch 1, **dadurch gekennzeichnet, dass**
- bei einem rechteckigen Querschnitt des Piezoaktors (1) die elektrisch positiven und negativen Außenelektroden (4,5) des Aktorteils und die elektrisch positiven und negativen Außenelektroden (10, 11 ) jedes Sensorteils jeweils an gegenüberliegenden Seiten des Piezoaktors (1) angebracht sind.

3. Piezoaktor nach Anspruch 2, **dadurch gekennzeichnet, dass**
- die Außenelektroden (4,5) sowohl des Aktorteils als auch die Außenelektroden (10,11) jedes Sensorteils nebeneinander auf zwei sich gegenüberliegenden Seiten des Piezoaktors (1) angeordnet sind.

4. Piezoaktor nach Anspruch 3, **dadurch gekennzeichnet, dass**
- bei den Sensorteilen die jeweiligen Innenelektroden (17,18,19,20) wechselseitig mit Außenelektroden an unterschiedlichen Flanken des Eckbereichs kontaktiert sind.

5. Piezoaktor nach einem der vorhergehenden Ansprüche, **dadurch gekennzeichnet, dass**
- mehrere mechanisch in Reihe geschaltete Sensorelemente elektrisch parallel geschaltet sind und/oder dass
- mehrere mechanisch in Reihe geschaltete Aktorelemente elektrisch parallel geschaltet sind.

## Claims

1. Piezo actuator having
- a multi-layer structure of piezo layers, inner electrodes (2, 3) which are arranged perpendicular to the operating direction (6, 7) between the piezo layers and to which an electrical voltage can be applied via outer electrodes in order to actuate the piezo actuator, and having
- further piezo layers with inner electrodes (8, 9) at which an electrical sensor signal proportional to the actuation of the piezo actuator (1) can be tapped off via further outer electrodes (10, 11),
- the piezo layers for the actuator part and the piezo layers for the at least one sensor part being integrated in a component in the form of a piezo actuator (1) in such a manner that individual sensor piezo layers are arranged at predefinable distances or in predefinable arrangements between the piezo layers for the actuator part, **characterized by**
- a plurality of sensor parts which are each individually contact-connected to outer electrodes, the respective sensor piezo layers (12, 13; 14, 15, 16) of the sensor parts being arranged beside one another in a plane transverse to the operating direction (6, 7), and,
- in these sensor parts, the inner electrodes (8, 9) each with the same polarity being contact-connected to outer electrodes in a parallel manner beside one another on one side of the piezo actuator (1) in the operating direction (6, 7) of the piezo actuator (1).

2. Piezo actuator according to Claim 1, **characterized in that**
- in the case of a rectangular cross section of the piezo actuator (1), the electrically positive and negative outer electrodes (4, 5) of the actuator part and the electrically positive and negative outer electrodes (10, 11) of each sensor part are each fitted to opposite sides of the piezo actuator (1).

3. Piezo actuator according to Claim 2, **characterized in that**
- both the outer electrodes (4, 5) of the actuator part and the outer electrodes (10, 11) of each sensor part are arranged beside one another on two opposite sides of the piezo actuator (1).

4. Piezo actuator according to Claim 3, **characterized in that**
- in the sensor parts, the respective inner electrodes (17, 18, 19, 20) are reciprocally contact-connected to outer electrodes on different flanks of the corner region.

5. Piezo actuator according to one of the preceding claims, **characterized in that**
- a plurality of sensor elements which are mechanically connected in series are electrically connected in parallel, and/or **in that**
- a plurality of actuator elements which are mechanically connected in series are electrically connected in parallel.

## Revendications

1. Actionneur piézoélectrique comprenant :
- une structure multicouche de couches piézoélectriques, des électrodes internes (2, 3) disposées perpendiculairement au sens de l'action (6, 7) entre les couches piézoélectriques, lesquelles peuvent être soumises à une tension électrique par le biais d'électrodes externes pour actionner l'actionneur piézoélectrique et comprenant
- des couches piézoélectriques supplémentaires avec des électrodes internes (8, 9) sur lesquelles un signal de détection électrique proportionnel à l'actionnement de l'actionneur piézoélectrique (1) peut être prélevé par le biais d'électrodes externes (10, 11) supplémentaires,
- les couches piézoélectriques pour la partie actionneur et les couches piézoélectriques pour l'au moins une partie de détection étant intégrées dans un composant sous forme d'actionneur piézoélectrique (1) de telle sorte que les couches piézoélectriques de détection individuelles sont disposées à des écarts ou selon des arrangements pouvant être prédéfinis entre les couches piézoélectriques pour la partie actionneur, **caractérisé par**
- une pluralité de parties de détection qui sont respectivement en contact individuellement avec les électrodes externes, les couches piézoélectriques de détection (12, 13 ; 14, 15, 16) respectives des parties de détection étant disposées les unes à côté des autres dans un plan transversal par rapport au sens de l'action (6, 7) et
- dans le cas de ces parties de détection, les électrodes internes (8, 9) sont en contact avec les électrodes externes d'un côté de l'actionneur piézoélectrique (1), parallèlement les unes aux autres et à chaque fois avec la même polarité dans le sens de l'action (6, 7) de l'actionneur piézoélectrique (1).

2. Actionneur piézoélectrique selon la revendication 1, **caractérisé en ce que**
- dans le cas d'une section transversale rectangulaire de l'actionneur piézoélectrique (1), les électrodes externes (4, 5) électriquement positives et négatives de la partie actionneur et les électrodes externes (10, 11) électriquement positives et négatives de chaque partie de détection sont respectivement montées sur des côtés opposés de l'actionneur piézoélectrique (1).

3. Actionneur piézoélectrique selon la revendication 2, **caractérisé en ce que**
- les électrodes externes (4, 5) de la partie actionneur ainsi que les électrodes externes (10, 11) de la partie de détection sont disposées les unes à côté des autres sur deux côtés opposés de l'actionneur piézoélectrique (1).

4. Actionneur piézoélectrique selon la revendication 3, **caractérisé en ce que**
- dans le cas de la partie de détection, les électrodes internes (17, 18, 19, 20) sont en contact par alternance avec les électrodes externes sur différents flancs de la zone de coin.

5. Actionneur piézoélectrique selon l'une des revendications précédentes, **caractérisé en ce que**
- plusieurs éléments de détection montés mécaniquement en série sont branchés électriquement en parallèle et/ou que
- plusieurs éléments d'actionnement montés mécaniquement en série sont branchés électriquement en parallèle.
